# EUROPÄISCHE PATENTANMELDUNG

(11) **EP 2 444 714 A2**
(43) Veröffentlichungstag der Anmeldung: **25.04.2012**
(21) Anmeldenummer: 11008219.5
(22) Anmeldetag: 12.10.2011
(51) Int. Cl.: F21K 99/00, F21Y 101/02, F21V 3/00

(54) **Leuchtanordnung, Verfahren zu deren Herstellung sowie Leuchtvorrichtung**

(30) Priorität: 22.10.2010 DE 102010049146
(71) Anmelder: Luxphoton SA, 8140 Bridel (LU)
(72) Erfinder: Tonhofer, Frederic, 8064 Bertrange (LU); Diamantidis, Georg, 56307 Dernbach (DE)
(74) Vertreter: Heinrich, Hanjo

(57) **Zusammenfassung**

Bei einer Leuchtanordnung trägt ein Leuchtchipsockel (30) wenigstens eine Halbleiterstruktur (34), die bei Spannungsbeaufschlagung eine Primärstrahlung emittiert und wenigstens bereichsweise von einem Lichtleitermaterial (92) umgeben ist. Ein von dem Leuchtchipsockel (30) getragenen Leuchtelement (32) umfasst ein Lichtleitermaterial (92) und durch die wenigstens eine Halbleiterstruktur (34) erzeugte Strahlung wird in das Lichtleitermaterial (92) des Leuchtelements (32) eingekoppelt. Der Leuchtchipsockel (30) und das Leuchtelement (32) weisen Mittel (84, 50, 60, 56; 84, 50, 56') auf, durch welche beim Zusammenfügen des Leuchtchipsockels (30) und des Leuchtelements (32) ein Strömungsweg (84, 50, 60, 56; 84, 50, 56') gebildet ist, über den überschüssiges Verbindungsmaterial (106, 92) aus einem Bereich zwischen den Lichtleitermaterialien (92) heraus fließen kann. Zudem ist eine Leuchtvorrichtung (10) angegeben.

## Beschreibung

Die Erfindung betrifft ein Verfahren zur Herstellung einer Leuchtanordnung, bei welchem
a) ein erstes Bauteil und ein zweites Bauteil zusammengefügt werden;
   wobei
b) ein Lichtleitermaterial des ersten Bauteils mit einem Lichtleitermaterial des zweiten Bauteils mittels eines Verbindungsmaterials verbunden wird.

Außerdem betrifft die Erfindung eine Leuchtanordnung mit
a) einem Leuchtchipsockel, welcher wenigstens eine Halbleiterstruktur trägt, die bei Spannungsbeaufschlagung eine Primärstrahlung emittiert und wenigstens bereichsweise von einem Lichtleitermaterial umgeben ist;
b) einem von dem Leuchtchipsockel getragenen Leuchtelement, welches ein Lichtleitermaterial umfasst;
   wobei
c) durch die wenigstens eine Halbleiterstruktur erzeugte Strahlung in das Lichtleitermaterial des Leuchtelements eingekoppelt wird.

Ferner betrifft die Erfindung eine Leuchtvorrichtung mit einem Anschlusssockel, der einen Kolben trägt, in dem eine Licht emittierende Leuchtanordnung angeordnet ist.

Derartige Leuchtanordnungen und Leuchtvorrichtungen sind beispielsweise aus der WO 2009/135620 A1 bekannt. In der Praxis hat sich gezeigt, dass es bei der Fertigung derartiger Leuchtanordnungen von großer Bedeutung ist, dass der durch das Verbindungsmaterial bewirkte Übergang von dem Lichtleitermaterial im Leuchtchipsockel zum Lichtleitermaterial im Leuchtelement homogen ist, um eine besonders gute Leuchtwirkung erzielen zu können.

Ein solcher gewünschter homogener Übergang kann beispielsweise dadurch erzielt werden, dass die Lichtleitermaterialien bei der Fertigung der Leuchtanordnung miteinander verklebt werden. Hierbei gibt es jedoch immer wieder Schwierigkeiten, da die Klebstoffmenge möglichst genau auf die Geometrie der zu verbindenden Bauteile abgestimmt sein muss, damit sich keine Luftblasen in der Verbindungsschicht ausbilden können oder zu viel Material zwischen den Bauteilen deren exaktes Zusammenfügen verhindert.

Es ist daher Aufgabe der vorliegenden Erfindung, ein Verfahren, eine Leuchtanordnung und eine Leuchtvorrichtung der eingangs genannten Art zu schaffen, bei denen in hohem Maße gewährleistet ist, dass sich bei der Herstellung der Leuchtanordnung oder der Leuchtvorrichtung ein homogener Übergang zwischen den Lichtleitermaterialien ausbildet.

Diese Aufgabe wird bei einem Verfahren der eingangs genannten Art dadurch gelöst, dass
c) das Verbindungsmaterial beim Zusammenfügen der beiden Bauteile fließfähig ist;
d) überschüssiges Verbindungsmaterial über einen Strömungskanal aus einem Bereich zwischen den Lichtleitermaterialien heraus geleitet wird, bis die beiden Bauteile zusammengefügt sind.

Somit kann beim Zusammenfügen der Bauteile stets eine etwas größere Menge an Verbindungsmaterial zwischen die zu verbindenden Lichtleitermaterialien gegeben werden, da überschüssiges Verbindungsmaterial von der Verbindungsstelle zwischen den Lichtleitermaterialien abgeführt werden kann. Wenn die beiden Bauteile vollständig zusammengefügt sind, verbleibt so zwischen den Lichtleitermaterialien exakt die Menge an Verbindungsmaterial, die auf Grund der Bauteil-Geometrie zwischen den Lichtleitermaterialien erforderlich ist.

Es ist vorstellbar, dass über einen Schlauch oder dergleichen ein vorübergehender Strömungskanal vom Bereich zwischen den Lichtleitermaterialien gebildet wird, der nach dem Zusammenfügen der Bauteile wieder entfernt wird. Es ist jedoch besonders vorteilhaft, wenn der Strömungskanal durch eines oder beide der Bauteile bereitgestellt wird.

Es ist günstig, wenn als Verbindungsmaterial ein Klebstoffmaterial verwendet wird. Es sind viele Arten von geeigneten Klebstoffen zum Verbinden von Lichtleitermaterialien bekannt, deren optische Eigenschaften vielen Anwendungen gerecht werden.

Alternativ kann als Verbindungsmaterial das Lichtleitermaterial eines der beiden Bauteile verwendet werden. In diesem Fall ist dieses vor dem und beim Zusammenfügen der Bauteile wenigstens in einem Oberflächenbereich fließfähig gehalten und härtet nach dem Zusammenfügen der Bauteile aus, so dass die Lichtleitermaterialien miteinander verbunden sind.

Im Hinblick auf die Leuchtanordnung der eingangs genannten Art wird die oben genannte Aufgabe dadurch gelöst, dass
d) der Leuchtchipsockel und das Leuchtelement Mittel aufweisen, durch welche beim Zusammenfügen des Sockels und des Leuchtelements ein Strömungsweg gebildet ist, über den überschüssiges Verbindungsmaterial aus einem Bereich zwischen den Lichtleitermaterialien heraus fließen kann.

Um diesen Strömungsweg beim Zusammenfügen des Leuchtchipsockels und des Leuchtelements zur Verfügung zu stellen, ist es von Vorteil, wenn der Leuchtchipsockel an einer dem Leuchtelement zugewandeten Seite eine Nut, insbesondere eine Ringnut, aufweist, welche einen Verbindungsbereich des Lichtleitermaterials des Leuchtchipsockels wenigstens teilweise umgibt und mit wenigstens einem Kanal kommuniziert, der von dem Lichtleitermaterial des Leuchtchipsockels wegführt.

Im Zusammenspiel mit dem Leuchtchipsockel ist es dann günstig, wenn das Leuchtelement einen oder mehrere zur Nut des Leuchtchipsockels komplementären Stege aufweist, die durch wenigstens einen Durchgang unterbrochen sind und in die Nut eingreifen, wenn der Leuchtchipsockel mit dem Leuchtelement verbunden ist.

Bei der Leuchtvorrichtung der eingangs genannten Art wird die oben angegebene Aufgabe dadurch gelöst, dass die Leuchtanordnung mit einem oder mehreren der gerade zur Leuchtanordnung erläuterten Merkmale ausgebildet ist.

Nachstehend werden Ausführungsbeispiele der Erfindung anhand der Zeichnungen näher erläutert. In diesen zeigen:
- Figur 1: einen Teilschnitt einer Kolbenlampe mit einer Leuchtanordnung, bei welcher ein Leuchtchipsockel und ein Leuchtelement zusammengefügt sind;
- Figur 2: eine perspektivische Ansicht der Leuchtanordnung von Figur 1;
- Figur 3: eine Ansicht der Leuchtanordnung von Figur 2, bei der der Leuchtchipsockel und das Leuchtelement voneinander getrennt gezeigt sind;
- Figur 4: eine weitere perspektivische Ansicht des Leucht-chipsockels;
- Figur 5: eine Aufsicht auf den Leuchtchipsockel;
- Figur 6: eine der Figur 3 entsprechende Ansicht der Leucht-anordnung aus einer anderen Blickrichtung;
- Figur 7: eine perspektivische Ansicht eines abgewandelten Leuchtchipsockels, wobei aufbondierte Halbleiter-strukturen zu erkennen sind;
- Figur 8: eine der Figur 7 entsprechende Ansicht des abge-wandelten Leuchtchipsockels, wobei die Halbleiter-strukturen von einem Lichtleitermaterial umgeben sind;
- Figur 9: einen Ansicht des Leuchtelements, bei der eine Koppeleinrichtung in Durchsicht und ein Gehäuse im Schnitt gezeigt ist.

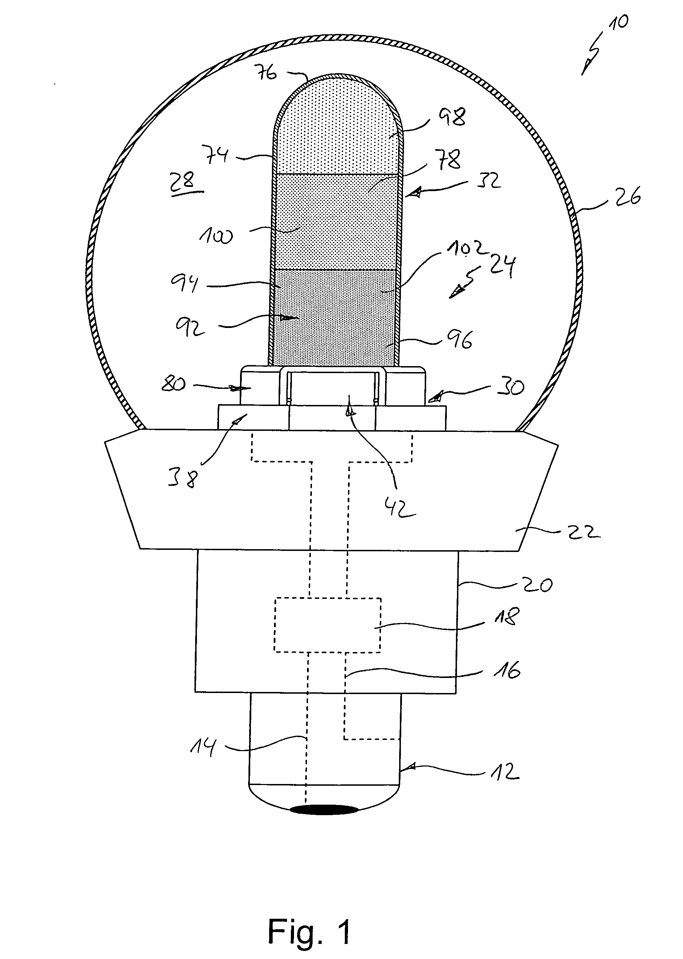

In Figur 1 ist mit 10 insgesamt eine Kolbenlampe bezeichnet, welche einen standardisierten Anschlusssockel 12 umfasst. Der Anschlusssockel 12 kann beispielsweise als Edison-Schraubsockel E27 oder E14 ausgebildet sein. Auch alle anderen standardisierten Anschlusssockel, wie ein Bajonettsockel, ein Stecksockel, ein Glasquetschsockel oder dergleichen, können vorgesehen sein.

Von den Anschlussbereichen des Anschlusssockels 12 verlaufen in dessen Inneren zwei Leitungen 14, 16, welche mit gestrichelten Linien gezeigt sind. Diese führen aus dem Anschlusssockel 12 zu einem Spannungswandler 18, der im Inneren eines von dem Anschlusssockel 12 getragenen Wandlergehäuses 20 angeordnet ist, und von dort durch einen Kühlkörper 22 zu einer Leuchtanordnung 24.

Die Kolbenlampe 10 umfasst einen Kolben 26 aus einem lichtdurchlässigen Material, beispielsweise aus Glas oder Epoxidharz, welcher gegebenenfalls die Funktion einer Sammeloptik erfüllen kann. Der Kolben 26 begrenzt zusammen mit dem Kühlkörper 22 einen Innenraum 28 der Kolbenlampe 10, in welchem die Leuchtanordnung 24 angeordnet ist.

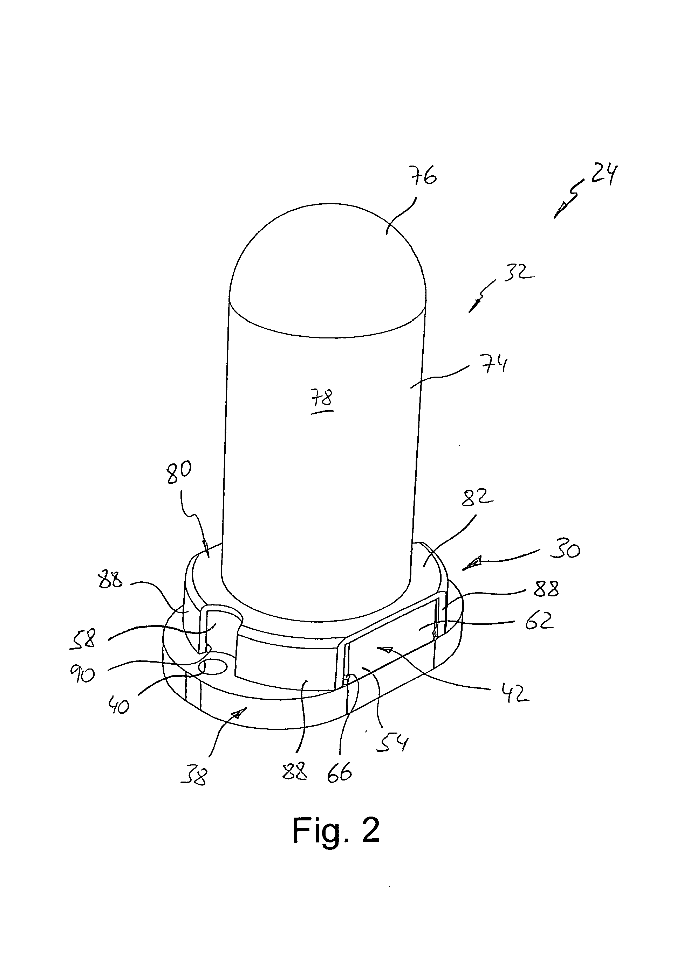

Die Leuchtanordnung 24 umfasst zwei Hauptbauteile in Form eines Leuchtchipsockels 30 und eines damit verbundenen Lichtleiterelements 32, welche in den Figuren 2 bis 9 detaillierter gezeigt sind.

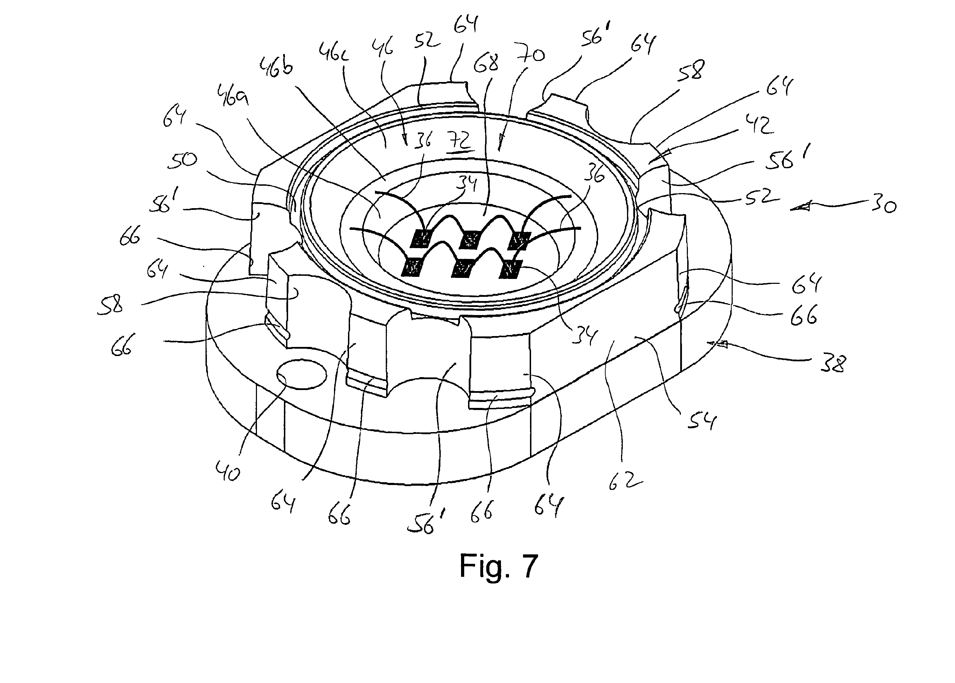

Wie in Figur 7 zu erkennen ist, ist der Leuchtchipsockel 30 der Kolbenlampe 10 beim vorliegenden Ausführungsbeispiel mit sechs Halbleiterstrukturen 34 bestückt. Es gibt hierbei zwei Sätze aus jeweils drei Halbleiterstrukturen 34, die mittels dünner Bonddrähte 36 in Reihe geschaltet sind, wobei die beiden Sätze ihrerseits parallel geschaltet sind.

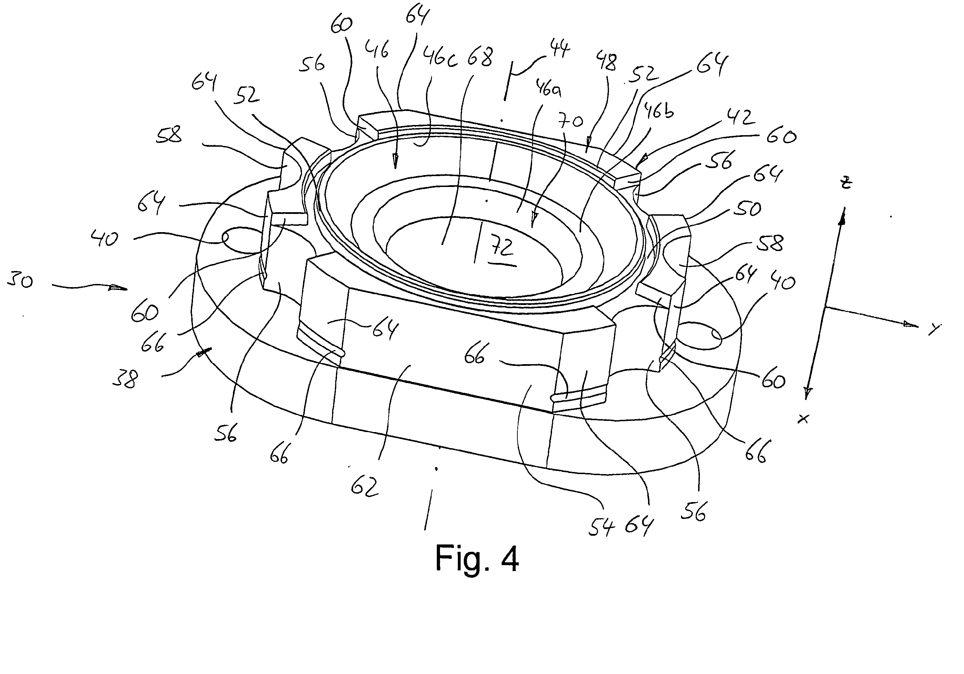

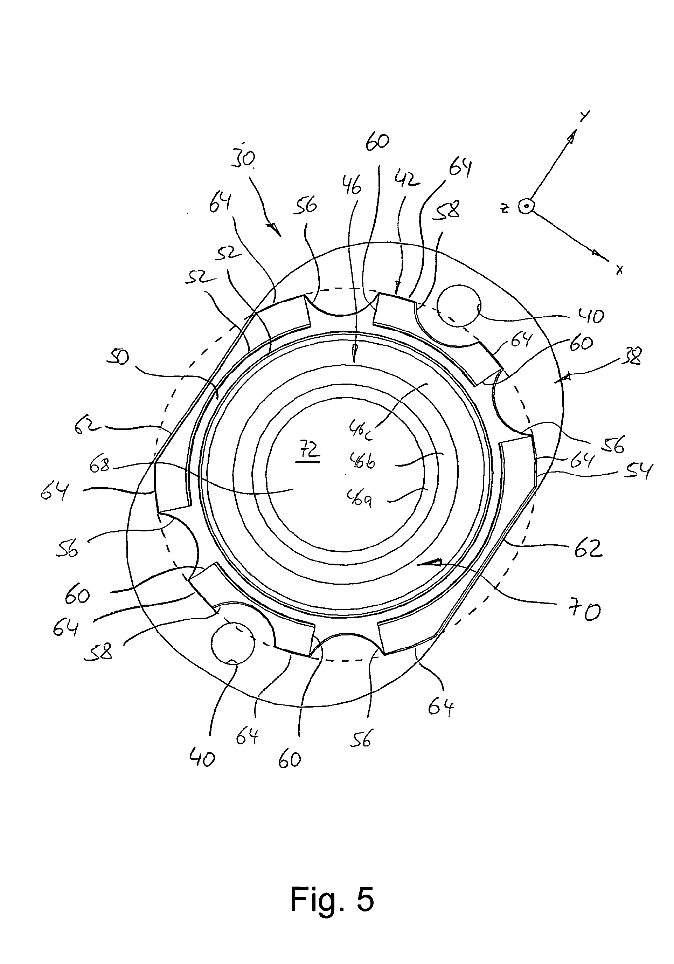

Der Leuchtchipsockel 30 wird nun anhand der Figuren 4 und 5 erläutert. Ein dort gezeigtes Bezugs-Koordinatensystem sei fest mit dem Leuchtchipsockel 30 verankert, so dass es sich mit dem Leuchtchipsockel 30 im Raum mitbewegt. Bezogen auf das Koordinatensystem bedeuten rechts die positive x-Richtung, vorne die positive y-Richtung und oben die positive z-Richtung. Die Richtungsangaben links, hinten und unten geben somit die jeweils entgegengesetzte Richtung an.

Der Leuchtchipsockel 30 umfasst eine Befestigungsplatte 38, die in ihren vorderen und hinteren Endbereichen jeweils eine Durchgangsbohrung 40 aufweist.

Im Bereich zwischen den Durchgangsbohrungen 40 trägt die Befestigungsplatte 38 einen Haltekranz 42 mit einer zur z-Richtung parallelen Mittelachse 44.

Der Haltekranz 42 weist eine zu seiner Mittelachse 44 koaxiale und insgesamt konische Stufenbohrung 46 auf. Die Stufenbohrung 46 hat einen unteren Konusabschnitt 46a, der sich von unten nach oben erweitert. Auf den unteren Konusabschnitt 46a folgt eine als Ringfläche 46b ausgebildete Stufe, die in einer xy-Ebene liegt und nach oben in einen oberen Konusabschnitt 46c übergeht, der sich seinerseits nach oben erweitert. Der Konuswinkel des unteren Konusabschnitts 46a ist dabei etwas kleiner als der Konuswinkel des oberen Konusabschnitts 46c.

In die von der Befestigungsplatte 38 abliegende Oberseite 48 des Haltekranzes 42 ist eine zu dessen Mittelachse 44 koaxiale Ringnut 50 eingearbeitet, welche die Stufenbohrung 46 umgibt. Die Nutkanten sind mit jeweils einer Fase 52 versehen.

Der Haltekranz 42 hat einen umlaufenden Außenrand 54 mit einer kreisrunden lichten Außenkontur, die in Figur 5 gestrichelt angedeutet ist.

In den umlaufenden Außenrand 54 des Haltekranzes 42 sind vier in z-Richtung verlaufende Rinnen 56 eingearbeitet, die in Richtung nach radial außen offen sind und im Querschnitt jeweils einem Kreisbogen folgen (siehe Figur 5). Jeweils zwei dieser Rinnen 56 sind auf einer Seite des Haltekranzes 42 vorhanden, die einer der Durchgangsbohrungen 40 der Befestigungsplatte 38 benachbart ist, wie dies in den Figuren zu erkennen ist.

In die Bereiche des Außenrands 54 des Haltekranz 42, die in y-Richtung jeweils unmittelbar neben einer der Durchgangsbohrungen 40 der Befestigungsplatte 38 ist jeweils eine parallel zu den Rinnen 56 verlaufende Ausnehmung 58 eingearbeitet, die im Querschnitt den Rinnen 56 entspricht und die jeweilige Durchgangsbohrung 40 in der Befestigungsplatte 38 koaxial umgibt. Durch die Ausnehmungen 58 kann ein Schraubenkopf einer durch eine Durchgangsbohrung 40 geführten Schraube an dem Haltekranz 42 vorbei geführt werden.

In die Oberseite 48 des Haltekranzes 42 sind außerdem vier Kanäle 60 eingearbeitet, die sich von der Ringnut 50 in Richtung nach radial außen bis zu jeweils einer der Rinnen 56 erstrecken. Die Kanäle 60 sind bezogen auf die Oberseite 48 des Haltekranzes 42 genauso tief wie die Ringnut 50 und verlaufen parallel zu einer xy-Ebene. Auf diese Weise verbindet jeweils ein Kanal 60 eine Rinne 56 mit der Ringnut 50.

Wie in Figur 5 gut zu erkennen ist, weist der Außenrand 54 des Haltekranzes 42 zwei in x-Richtung gegenüberliegende und in einer yz-Ebene verlaufende ebene Randabschnitte 62 auf. Zwischen diesen Randabschnitten 62 und den benachbarten Rinnen 56 und zwischen den Rinnen 56 und den Ausnehmungen 58 verbleiben entsprechend konvex gekrümmte Randabschnitte 64, die in einer xy-Ebene jeweils einem Kreisbogen folgen.

Jeder dieser konvexen Randabschnitte 64 weist unten, d.h. nahe der Befestigungsplatte 38, eine Rastnut 66 auf, die in einer xy-Ebene verläuft und von denen vier in Figur 4 zu erkennen sind.

Die Befestigungsplatte 38 ist so ausgebildet, dass sie der tatsächlichen Außenkontur des Haltekranzes 42 im Bereich von dessen ebenen Randabschnitte 62 folgt, ansonsten jedoch über den Haltekranz 42 übersteht.

Insgesamt ist der Haltekranz 42 symmetrisch zu Spiegelebenen ausgebildet, die parallel zur xz- oder yz-Ebene und durch die Mittelachse 44 des Haltekranzes 42 verlaufen.

Der Oberflächenbereich der Befestigungsplatte 38, der von dem unteren Konusabschnitt 46a der Stufenbohrung 46 des Haltekranzes 42 umgeben ist, bildet einen planen Boden 68, so dass in Verbindung mit der Stufenbohrung 46 eine Wanne 70 ausgebildet ist, die einen Bondierraum 72 für die Halbleiterstrukturen 34 vorgibt.

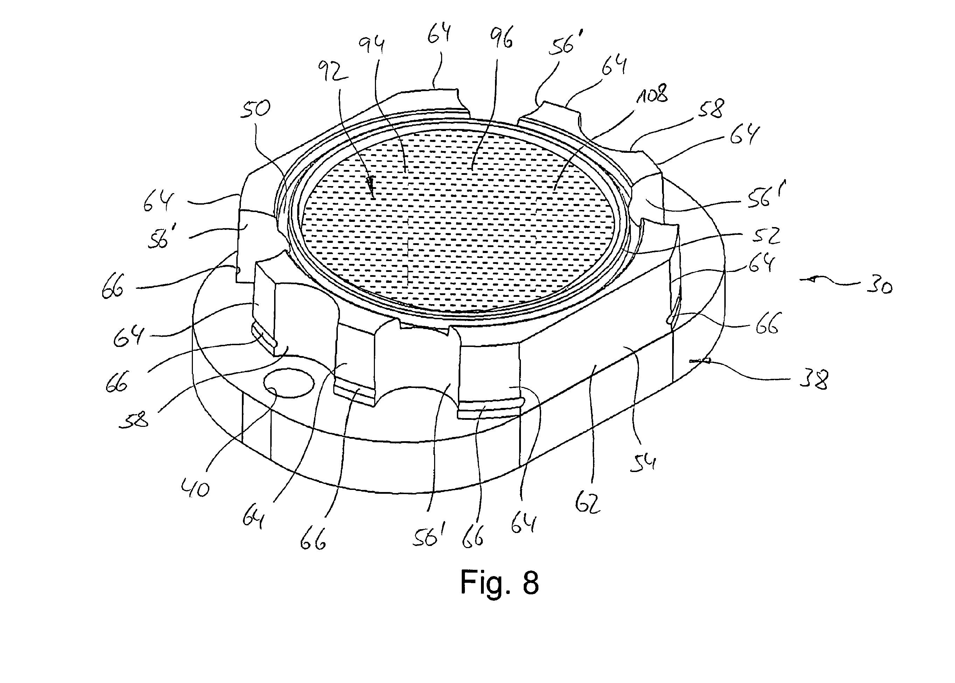

In den Figuren 7 und 8 ist eine Abwandlung des Leuchtchipsockels 30 gezeigt, bei dem der Haltekranz abgewandelte Rinnen 56', jedoch keine Kanäle 60 umfasst. Die abgewandelten Rinnen 56' sind tiefer in den Außenrand 54 des Haltekranzes 42 eingearbeitet als die Rinnen 56 bei dem Leuchtchipsockel 30 gemäß der Figuren 1 bis 6, und zwar so tief, dass die Rinnen 56' in die Ringnut 50 einschneiden und dadurch direkt mit der Ringnut 50 verbunden ist.

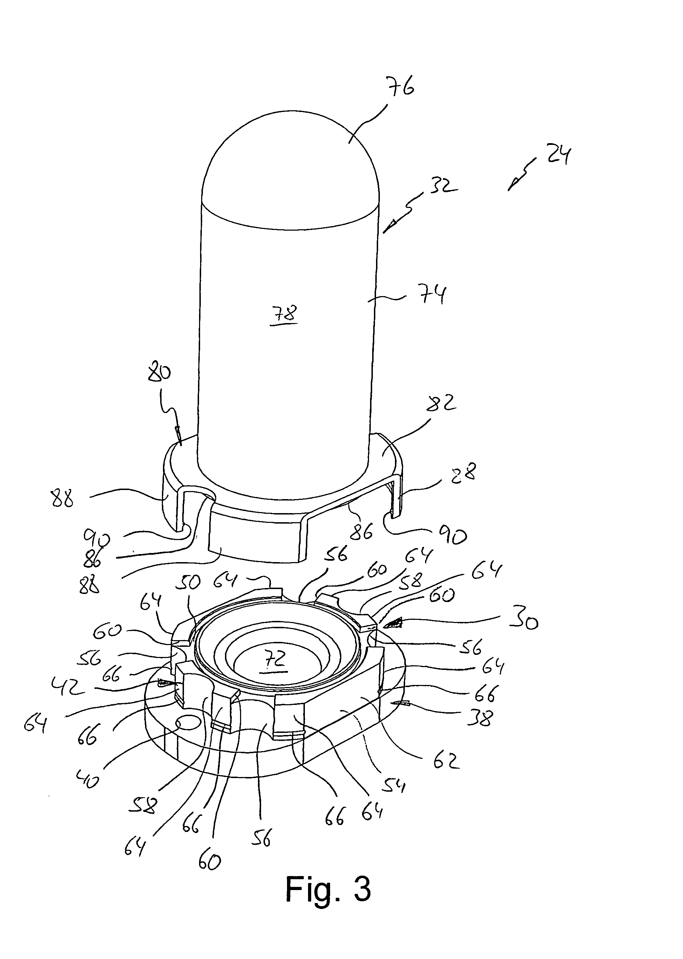

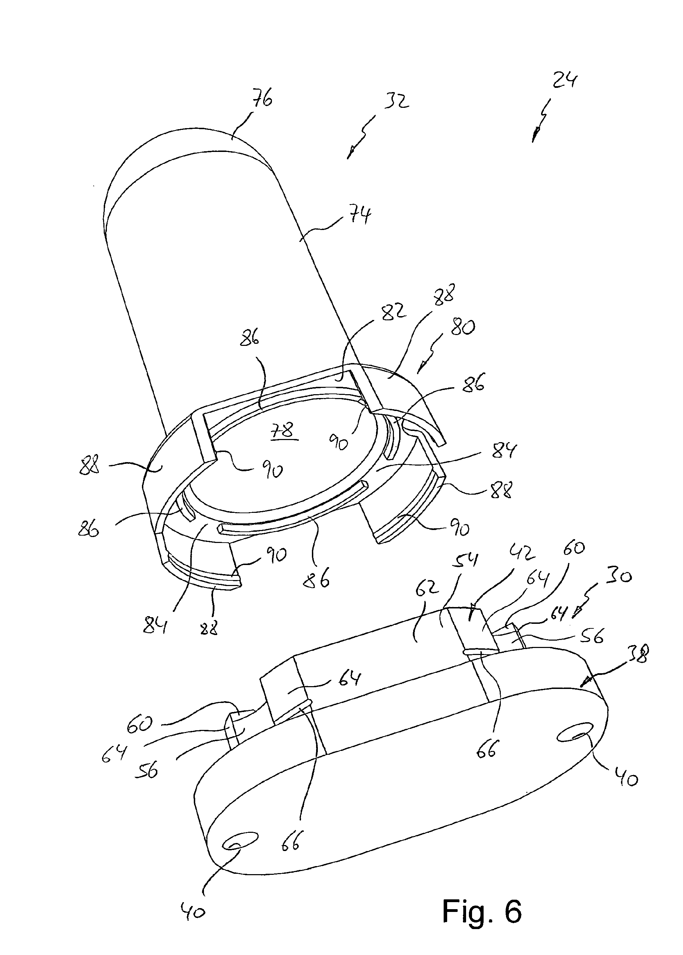

Das in den Figuren 3 und 6 gut zu erkennende Leuchtelement 32 umfasst ein hohlstabförmiges Gehäuse 74 mit kreisrundem Querschnitt, dessen erstes Ende als Halbkugel 76 ausgebildet ist und welches eine Kammer 78 begrenzt, die am gegenüberliegenden zweiten Ende des Gehäuses offen ist. Das Gehäuse 74 ist aus Kunststoff, insbesondere aus Polycarbonat, gefertigt und kann klar oder matt transparent sein. Das Gehäuse 74 ist beispielsweise im Spritzgussverfahren gefertigt, wie es an und für sich bekannt ist.

In der Praxis beträgt der Durchmesser der Kammer 78 im Gehäuse 74 des Leuchtelements 32 beispielsweise zwischen 1 mm und 300 mm, bevorzugt zwischen 1 mm und 200 mm und nochmals bevorzugt zwischen 3 mm und 30 mm. Die Höhe der Kammer 78 beträgt in der Praxis beispielsweise zwischen 3 mm und 300 mm, bevorzugt zwischen 3 mm und 150 mm und nochmals bevorzugt zwischen 10 mm und 60 mm.

Am dem offenen zweiten Ende trägt das Gehäuse 74 eine Koppeleinrichtung 80, die zu dem Haltekranz 42 des Leuchtchipsockels 30 komplementär ist.

Die Koppeleinrichtung 80 umfasst einen Auflagekragen 82, der das Gehäuse 74 des Leuchtelements 32 an dessen offenem Ende in Umfangsrichtung umgibt. Auf seiner in Richtung von dem Gehäuse 74 weg weisenden Seite trägt der Auflagekragen 82 einen durch vier Durchgänge 84 unterbrochenen Steg 86, so dass vier Stegabschnitte gebildet sind, deren Geometrie und Anordnung komplementär zur Ringnut 50 des Haltekranzes 42 ist. So kann das Leuchtelement 32 derart auf die Haltekranz-Oberseite 48 des Leuchtchipsockels 30 aufgesetzt werden, dass die Stege 86 in die Ringnut 50 des Haltekranzes 42 eingreifen und der Auflagekragen 82 auf der Oberseite 48 des Haltekranzes 42 aufliegt.

Die Durchgänge 84 zwischen den Stegen 86 sind so bemessen und angeordnet, dass sie den Kanäle 60 des Haltekranzes 42 benachbart sind, wenn das Leuchtelement 32 mit dem Leuchtchipsockel 30 verbunden ist. Grundsätzlich können die Durchgänge 84 jedoch frei angeordnet sein. Es reicht gegebenenfalls aus, wenn lediglich ein einziger Durchgang 84 vorhanden ist.

Vom Außenrand des Auflagekragens 78 erstrecken sich vier Klemmwände 88 in Richtung von dem Gehäuse 90 weg. Die Klemmwände 88 sind komplementär zu den konvexen Wandabschnitten 64 des Haltekranzes 42 ausgebildet. Dazu tragen sie in entsprechender Höhe nach innen vorragende Rastnasen 90, die ihrerseits komplementär zu den Rastnuten 66 des Haltekranzes 42 ausgebildet sind.

Wie in Figur 8 zu erkennen ist, ist der Bondierraum 72 des Haltekranzes 42 mit einem Trägermedium 92 derart gefüllt, dass dessen Oberfläche mit dem Nutgrund der Ringnut 50 fluchtet. Das Trägermedium 92 kann beispielsweise in Form eines elastischen Silikonmaterials vorliegen. In dem Silikonmaterial 92 sind Leuchtstoffpartikel 94 und gegebenenfalls Reflexionspartikel 96 verteilt, die durch das Silikonmaterial 92 in ihrer Lage gehalten sind. Das Trägermedium 92 mit oder ohne Leuchtstoffpartikel 94 oder Reflexionspartikel 96 dient als Lichtleitermaterial.

Als Material für die Reflexionspartikel 96 kommen insbesondere Bariumsulfid, Bariumsulfit, Bariumsulfat oder Titandioxid in Frage. Alternativ können als Material für die Reflexionspartikel 96 auch Scandiumoxid oder Zinksulfid sowie Oxide von Lanthan und der Seltenen Erdmetalle verwendet werden.

Die Halbleiterstrukturen 34 strahlen bei Anlegen einer Spannung ultraviolettes Licht sowie blaues Licht in einem Wellenlängenbereich von 420 nm bis 480 nm ab. Durch das die Halbleiterstrukturen 34 umhüllende Silikonmaterial 92 mit den Leuchtstoffpartikeln 94 kann eine Weißlicht-Kolbenlampe 10 erhalten werden. Die Leuchtstoffpartikel 94 sind aus Festkörpermaterialien gefertigt, die Farbzentren aufweisen. Um die ultraviolette und blaue Primärstrahlung der Halbleiterstrukturen 34 in Weißlicht umzuwandeln, werden z.B. drei Arten von Leuchtstoffpartikeln 94 verwendet, die das ultraviolette und blaue Licht teilweise absorbieren und selber im Gelben und Roten emittieren. Falls gewünscht, können zusätzlich Leuchtstoffpartikel 94 verwendet werden, welche selber im Blauen emittieren. Auf diese Weise wird vorzugsweise eine Lichttemperatur von 15.000°K bis 30.000°K, bevorzugt von 20.0000°K bis 25.000°K erzielt.

Durch die gegebenenfalls vorhandenen Reflexionspartikel 96 wird die von den Halbleiterstrukturen 34 emittierte Strahlung innerhalb des Silikonmaterials 92 weitergeleitet.

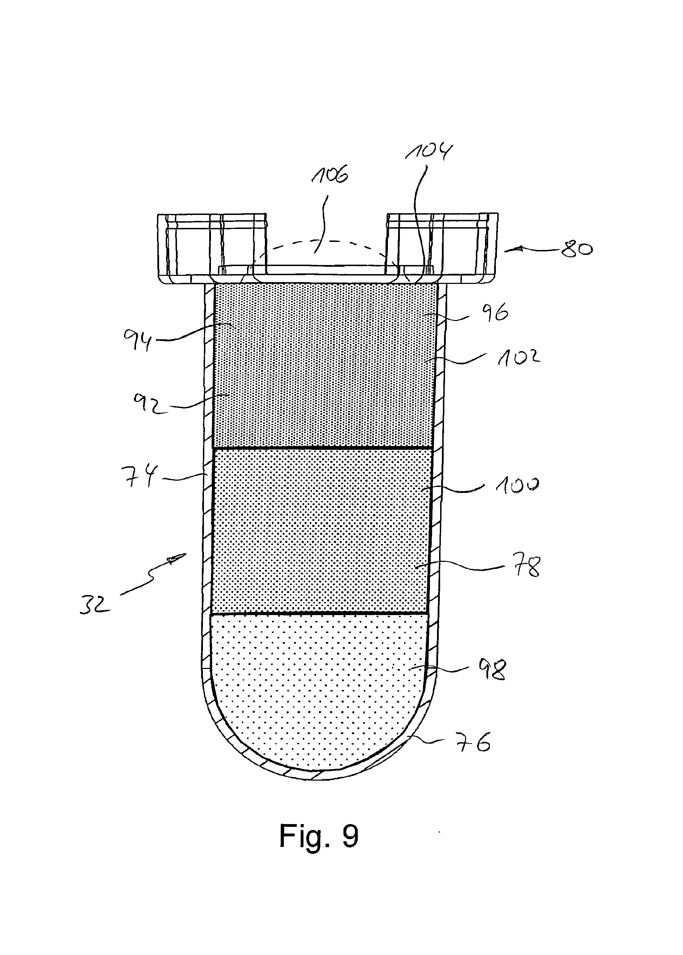

Wie in den Figuren 1 und 9 zu erkennen ist, ist auch die Kammer 78 des Leuchtelements 32 mit als Lichtleitermaterial wirkendem Trägermedium 92 in Form eines elastischen Silikonmaterials gefüllt, in der Leuchtstoffpartikel 94 und gegebenenfalls Reflexionspartikel 96 verteilt sind, die durch das Silikonmaterial 92 in ihrer Lage gehalten sind.

Die Konzentration oder anders ausgedrückt die Teilchenzahldichte der Leuchtstoffpartikel 94 und der Reflexionspartikel 96 ändert sich in Richtung auf die Halbkugel 76 am einen Ende des Gehäuses 74 und nimmt in dieser Richtung ab. Beim vorliegenden Ausführungsbeispiel sind drei Schichten 98, 100 und 102 in der Kammer 78 des Leuchtelements 32 vorhanden.

Die größte Teilchenzahldichte der Leuchtstoffpartikel 94 und der Reflexionspartikel 96 liegt in der ersten Schicht 98 des Silikonmaterials 92 vor, welche den Halbleiterstrukturen 34 im Leuchtchipsockel 30 am nächsten angeordnet ist, wenn dieser mit dem Leuchtelement 32 verbunden ist. Die kleinste Teilchenzahldichte der Leuchtstoffpartikel 94 und der Reflexionspartikel 96 liegt in der dritten Schicht 102 des Silikonmaterials 92 vor, welche am weitesten von den Halbleiterstrukturen 34 im Leuchtchipsockel 30 abliegt, wenn dieser mit dem Leuchtelement 32 verbunden ist.

In Abwandlung können auch mehr oder weniger als drei Schichten 98, 100 und 102 aus Silikonmaterial mit einem entsprechenden Konzentrationsgradienten der Leuchtstoffpartikel 94 und der Reflexionspartikel 96 vorhanden sein.

Bei der Herstellung der Kolbenlampe 10 wird die Kammer 78 des Leuchtelements 32 schichtweise gefüllt, indem z.B. dünnflüssiges Silikonöl verwendet wird, welches vorher mit einem Härter und der für die jeweils gewünschte Teilchenzahldichte notwendigen Menge Leuchtstoffpartikel 94 und Reflexionspartikel 96 vermischt wurde. Nach dem Aushärten einer ersten Schicht kann jeweils entsprechend eine weitere Schicht Silikonmaterial 92 mit Leuchtstoffpartikeln 94 und Reflexionspartikeln 96 auf der ersten Schicht hergestellt werden.

In der Praxis erfolgt das Herstellen des Leuchtchipsockels 30 und des Leuchtelements 32 sowie deren Befüllen mit dem Silikonmaterial 92 unter Reinraumbedingungen, vorzugsweise nach der Reinraumklasse ISO 7.

Es wird eine Befüllanlage verwendet, die ein Fördersystem umfasst, mit dem zu befüllende Leuchtelemente 32 hintereinander zu mehreren aufeinander folgenden Misch- und Dosierstation gefördert werden. In diesen Misch- und Dosierstationen wird jeweils die benötigte Zusammensetzung des Silikonmaterials 92 im Hinblick auf die Art und die Konzentrationen von Silikon, Härter, Leuchtstoffpartikeln 94 und Reflexionspartikeln 96 angemischt. Diese Mischung wird dann im Vakuum in das zu befüllende Leuchtelement 32 gefüllt. Dabei werden die Leuchtelemente 32 z.B. in Förderkörben gefördert, in denen jeweils mehrere Bauteile gefördert werden können, so dass in einem Arbeitsgang pro Station mehrere Leuchtelemente 32 mit einer Schicht aus Silikonmaterial 92 gefüllt werden.

Wenn wie beim vorliegend beschriebenen Ausführungsbeispiel drei Schichten 98, 100 und 102 in dem Leuchtelement 32 erzeugt werden sollen, sind entsprechend drei Misch- und Dosierstationen vorhanden.

Die Schichten aus Silikonmaterial 92 in dem Leuchtelement 32 können auch andere Geometrien haben. Beispielsweise kann das Leuchtelement 32 beim Befüllvorgang gegenüber einer Vertikalen verkippt angeordnet werden, so dass bezogen auf die Längsachse des Leuchtelements 32 schräge Schichten bzw. Grenzflächen erzeugt werden können. Darüber hinaus kann die Kammer 78 des Gehäuses 74 in Unterkammern unterteilt sein, die mit jeweils verschiedenen Silikonmaterialien 92 unterschiedlicher Zusammensetzung befüllt werden können.

Wie oben erläutert, muss nach dem Einfüllen einer Schicht aus Silikonmaterial 92 gewartet werden, bis diese Schicht ausgehärtet ist, bevor eine weitere Schicht auf die vorhandene Schicht gegeben werden kann. Hierzu umfasst jede Misch- und Dosierstation Pufferzonen, in denen die Förderkörbe über einen notwendigen Zeitraum zwischengelagert werden.

Bei der Berechnung der pro Schicht aus Silikonmaterial 92 einzufüllenden Materialmenge muss jeweils eine gewisse Schrumpfung berücksichtigt werden, die beim Aushärten des Silikonmaterials 92 stattfindet und von der Materialzusammensetzung des konkret verwendeten Silikonmaterials 92 abhängt.

Die Leuchtchipsockel 30 werden in einer eigenen Misch- und Dosierstation mit dem für sie bestimmten Silikonmaterial 92 befüllt. Zunächst werden die Leuchtchipsockel 30 jedoch in einem vorhergehenden Schritt in an und für sich bekannter Weise mit den Halbleiterstrukturen 34 bestückt. Hierbei ist die Anzahl der verwendeten Halbleiterstrukturen 34 in großem Umfang variabel und kann auch mehr oder weniger als die in Figur 7 gezeigten sechs Halbleiterstrukturen 34 umfassen. Die Halbleitstrukturen 34 werden auf den Boden 68 der Bondierwanne 70 gesetzt und in an und für sich bekannter Weise über die Bonddrähte 36 mit der Ringfläche 46b der Bondierwanne 42 verbunden.

Die Ringfläche 46b bildet einen Kontaktbereich zum Anschluss der Halbleiterstrukturen 34. Die Ringfläche 46b ist über nicht eigens gezeigte Leitungen, die durch den Haltekranz 42 und die Befestigungsplatte 38 hindurch verlaufen, mit ebenfalls nicht eigens gezeigten Anschlussflächen an der Befestigungsplatte 38 verbunden. Über diese Anschlussflächen können die Halbleiterstrukturen 34 in der Kolbenlampe 10 dann mit dem Spannungswandler 18 verbunden und mit Spannung beaufschlagt werden.

Mit der Misch- und Dosierstation für den Leuchtchipsockel 30 wird dessen Bondierraum 72 nun bis zu dem gewünschten Pegel mit dem Silikonmaterial 92 gefüllt. Das Silikonmaterial 92 kann z.B. anders als es in Figur 7 gezeigt ist auch mit der Oberseite 48 des Haltekranzes 42 bündig abschließen.

Hierzu kann ebenfalls dünnflüssiges Silikonöl verwendet werden, welches vorher mit einem Härter und einer vorgegebenen Menge Leuchtstoffpartikel 94 und Reflexionspartikel 96 vermischt wurde. Das Silikonöl härtet dann in an und für sich bekannter Weise zu einem elastischen Silikonmaterial 92 aus.

Die nun befüllten Leuchtchipsockel 30 und die befüllten Leuchtelemente 32 werden dann zu einer Montageeinheit gefördert, wo sie miteinander verbunden werden.

Bei einer ersten Variante werden Leuchtelemente 32 mit vollständig ausgehärtetem Silikonmaterial 92 mit Leuchtchipsockeln 30 verbunden. Hierzu wird auf den Verbindungsbereich des Silikonmaterials 92 des Leuchtelements, der durch die in Figur 9 mit 104 bezeichnete und von außen zugängliche Grenzfläche der äußeren, vorliegend der dritten Schicht 102 aus Silikonmaterial 92 gebildet ist, eine vorgegebene Menge eines fließfähigen Verbindungsmaterials aufgetragen. Dieses Verbindungsmaterial wirkt nach einem Vernetzungs- oder Aushärtungsprozess als Verbindungsschicht oder Klebstoff und verbindet das Silikonmaterial 92 des Leuchtelements 32 mit dem Silikonmaterial 92 im Bondierraum 72 des Leuchtchipsockels 30. Ein Tropfen aus einem solchen Verbindungsmaterials 106 ist in Figur 9 gestrichelt angedeutet.

Nun wird der Leuchtchipsockel 30 mit seinem Haltekranz 42 zwischen die Klemmwände 88 der Koppeleinrichtung 80 des Leuchtelements 32 geführt und koaxial zum Leuchtelement 32 auf dieses zu bewegt. Die Klemmwände 88 sind in gewissem Umfang flexibel, so dass sie in dem Maße nach radial außen ausweichen können, wie es die Rastnasen 90 erfordern.

Der durch die äußere Grenzfläche des Silikonmaterials 92 in dem Leuchtchipsockel 30 gebildete Verbindungsbereich für dessen Silikonmaterial 92 ist in Figur 8 mit 108 bezeichnet. Wenn dieser Verbindungsbereich 108 nun bei der Bewegung des Leuchtchipsockels 30 in Richtung auf das Gehäuse 74 des Leuchtelements 32 auf den Materialtropfen 106 trifft, weicht das fließfähige Verbindungsmaterial 106 zur Seite aus, so dass sich zwischen den Grenzflächen 104 und 108 der Silikonmaterialien 92 eine homogene Schicht aus dem Verbindungsmaterial 106 ausbildet.

Der Leuchtchipsockel 30 wird so lange auf das Leuchtelement 32 zu bewegt, bis die Rastnasen 90 an den Klemmwänden 88 der Koppeleinrichtung 80 des Leuchtelements 32 in die komplementären Rastnuten 66 des Leuchtchipsockel 30 einrasten. Dann sind der Leuchtchipsockel 30 und das Leuchtelement 32 ordnungsgemäß zusammengefügt.

Bei der Bewegung des Leuchtchipsockels 30 und des Leuchtelemente 32 auf einander zu bildet sich zwischen den Silikonmaterialien 92 im Leuchtchipsockel 30 und im Leuchtelement 32 ein Bereich aus, dessen Volumen immer kleiner wird und der dann, wenn der Leuchtchipsockel 30 mit dem Leuchtelement 32 verbunden ist, sein kleinstes Volumen hat und vollständig mit Verbindungsmaterial 106 gefüllt ist.

Beim der Bewegung des Leuchtchipsockels 30 und des Leuchtelemente 32 auf einander zu wird Verbindungsmaterial 106 nach radial außen zunächst in die Ringnut 50 des Leuchtchipsockels 30 gedrückt.

Auch wenn die Stege 86 am Auflagekragen 80 des Leuchtelements 32 bereits teilweise in die Ringnut 50 hineinragen, kann das Verbindungsmaterial 106 durch die Durchgänge 84 zwischen den Stegen 86 hindurch strömen, so dass es über den radial innen liegenden Rand der Ringnut 50 aus dem erläuterten Verbindungsbereich in dieselbe strömen kann. Überschüssiges Verbindungsmaterial 106 kann dann aus der Ringnut 50 über die Kanäle 60 und die Rinnen 56 oder bei der Abwandlung direkt über die Rinnen 56' abfließen, wodurch das Leuchtelement 32 und der Leuchtchipsockel 30 passgenau auf- und aneinander gefügt werden können.

Somit kann überschüssiges Verbindungsmaterial 106 aus dem Bereich zwischen den Silikonmaterialien 92 des Leuchtchipsockels 30 und des Leuchtelements 32 heraus fließen, der sich beim Zusammenfügen des Leuchtchipsockels 30 mit dem Leuchtelement 32 zwischen den zu verbindenden Lichtleitermaterialien 92 bildet.

Im Betrieb der Leuchtanordnung 24 wird Strahlung, die im Leuchtchipsockel 30 durch die Halbleiterstrukturen 34 erzeugt wird, d.h. in diesem Fall auch eine von den Leuchtstoffpartikeln 94 in dessen Silikonmaterial 92 erzeugte Sekundärstrahlung, in das Silikonmaterial 92 des Leuchtelements 32 eingekoppelt.

Wenn die Klemmwände 88 des Leuchtelements 32 mit dem Außenrand 54 des Leuchtchipsockels 30 verrastet sind, liegt der Auflagekragen 82 des Leuchtelements 32 flächig auf der Oberseite 48 des Leuchtchipsockels 30 auf und die Stege 86 greifen vollständig in die Ringnut 50 ein. Daher kann dann kein weiteres Verbindungsmaterial 106 mehr abfließen, da der Zugang zu den Kanälen 60 bzw. den Rinnen 56 oder 56' versperrt ist. Nun kann das Verbindungsmaterial 106 aushärten. Die so fertig gestellte Leuchtanordnung 24 kann dann in einer Prüfstation auf ihre Funktionsfähigkeit und ihre Leuchtwirkung geprüft werden. Wenn alle Qualitätsanforderungen erfüllt sind, kann die Leuchtanordnung 24 dann in einem entsprechenden Lampenrohling zu einer Kolbenlampe 10 verbaut werden.

Anstelle des Tropfens aus einem gesonderten Verbindungsmaterial 106 kann auch derart vorgegangen werden, dass der Leuchtchipsockel 30 und das Leuchtelement 32 zusammengefügt werden, bevor die letzte, beim vorliegenden Ausführungsbeispiel also die dritte Schicht 102 aus Silikonmaterial 92 ausgehärtet ist. In diesem Fall wird das Silikonmaterial 92 für die Schicht 102 in einer Menge eingefüllt, bei der sichergestellt ist, dass das Silikonmaterial 92 über die gewünschte Materialgrenzfläche, die in Figur 9 mit 104 bezeichnet ist, übersteht.

Beim Zusammenführen des Leuchtchipsockels 30 und des Leuchtelements 32 verhält sich das überschüssige Silikonmaterial 92 in der Weise, wie es oben für den Materialtropfen 106 erläutert ist. Dies bedeutet, dass überschüssiges Silikonmaterial 92 zwischen den Verbindungsbereichen 104 und 108 über die Kanäle 60 und die Rinnen 56 bzw. direkt über die Rinnen 56' abgeführt wird. In diesem Fall darf das Silikonmaterial 92 beim Aushärten möglichst wenig schrumpfen. Bei diesem Vorgehen wirkt also das Silikonmaterial 92 selbst als Verbindungsmaterial zwischen dem Silikonmaterial 92 in dem Bondierraum 72 des Leuchtchipsockels 30 und dem Silikonmaterial 92 in der Kammer 78 des Leuchtelements 32.

Unabhängig davon, ob ein gesondertes Verbindungsmaterial 106 oder Silikonmaterial 92 verwendet wird, um das Silikonmaterial 92 im Leuchtelement 32 mit dem Silikonmaterial 92 im Leuchtchipsockel 30 zu verbinden, bilden die Durchgänge 84 zwischen den Stegen 86 des Leuchtelements 32 mit der Ringnut 50, den Kanälen 60 und den Rinnen 56 bzw. mit der Ringnut 50 und den Rinnen 56' einen Strömungsweg. Durch diesen kann überschüssiges Verbindungsmaterial, also Material 106 oder noch fließfähiges Silikonmaterial 92, aus dem Bereich, der sich beim Zusammenfügen des Leuchtchipsockels 30 und des Leuchtelements 32 zwischen deren Silikonmaterialien 92 ausbildet, abfließen.

Bei einer Abwandlung kann das Trägermedium 92 aus einem im ausgehärteten Zustand lichtdurchlässigen Harz sein, beispielsweise aus einem Epoxidharz oder einem Polyesterharz. In diesem Fall können die Schichten 98, 100 und 102 jeweils durch Aushärten von Schichten eines flüssig aufgetragenen Harzes gewonnen werden, welchem dazu ein Härter zugegeben wurde, wie es an und für sich bekannt ist, und welches vorher mit der für die jeweils gewünschte Teilchenzahldichte notwendigen Menge Leuchtstoffpartikel 94 und Reflexionspartikel 96 vermischt wurde.

## Patentansprüche

1. Verfahren zur Herstellung einer Leuchtanordnung, bei dem
a) ein erstes Bauteil (30) und ein zweites Bauteil (32) zusammengefügt werden;
wobei
b) ein Lichtleitermaterial (92) des ersten Bauteils (30) mit einem Lichtleitermaterial (92) des zweiten Bauteils (32) mittels eines Verbindungsmaterials (106; 92) verbunden wird, **dadurch gekennzeichnet, dass**
c) das Verbindungsmaterial (106; 92) beim Zusammenfügen der beiden Bauteile (30, 32) fließfähig ist;
d) überschüssiges Verbindungsmaterial (106; 92) über einen Strömungskanal (84, 50, 60, 56; 84, 50, 56') aus einem Bereich zwischen den Lichtleitermaterialien (92) heraus geleitet wird, bis die beiden Bauteile (30, 32) zusammengefügt sind.

2. Verfahren nach Anspruch 1, **dadurch gekennzeichnet, dass** der Strömungskanal durch eines oder beide der Bauteile (30, 32) bereitgestellt wird.

3. Verfahren nach Anspruch 1 oder 2, **dadurch gekennzeichnet, dass** als Verbindungsmaterial (106) ein Klebstoffmaterial (106) verwendet wird.

4. Verfahren nach Anspruch 1 oder 2, **dadurch gekennzeichnet, dass** als Verbindungsmaterial (92) das Lichtleitermaterial (92) eines der beiden Bauteile (30, 32) verwendet wird.

5. Leuchtanordnung mit
a) einem Leuchtchipsockel (30), welcher wenigstens eine Halbleiterstruktur (34) trägt, die bei Spannungsbeaufschlagung eine Primärstrahlung emittiert und wenigstens bereichsweise von einem Lichtleitermaterial (92) umgeben ist;
b) einem von dem Leuchtchipsockel (30) getragenen Leuchtelement (32), welches ein Lichtleitermaterial (92) umfasst;
wobei
c) durch die wenigstens eine Halbleiterstruktur (34) erzeugte Strahlung in das Lichtleitermaterial (92) des Leuchtelements (32) eingekoppelt wird,
**dadurch gekennzeichnet, dass**
d) der Leuchtchipsockel (30) und das Leuchtelement (32) Mittel (84, 50, 60, 56; 84, 50, 56') aufweisen, durch welche beim Zusammenfügen des Leuchtchipsockels (30) und des Leuchtelements (32) ein Strömungsweg (84, 50, 60, 56; 84, 50, 56') gebildet ist, über den überschüssiges Verbindungsmaterial (106, 92) aus einem Bereich zwischen den Lichtleitermaterialien (92) heraus fließen kann.

6. Leuchtanordnung nach Anspruch 5, **dadurch gekennzeichnet, dass** der Leuchtchipsockel (30) an einer dem Leuchtelement (32) zugewandeten Seite eine Nut (50), insbesondere eine Ringnut, aufweist, welche einen Verbindungsbereich (108) des Lichtleitermaterials (92) des Leuchtchipsockels (30) wenigstens teilweise umgibt und mit wenigstens einem Kanal (60, 56; 56') kommuniziert, der von dem Lichtleitermaterial (92) des Leuchtchipsockels (30) wegführt.

7. Leuchtanordnung nach Anspruch 6, **dadurch gekennzeichnet, dass** das Leuchtelement (32) einen oder mehrere zur Nut (50) des Leuchtchipsockels (30) komplementäre Stege (86) aufweist, die durch wenigstens einen Durchgang (84) unterbrochen sind und in die Nut (50) eingreifen, wenn der Leuchtchipsockel (30) mit dem Leuchtelement (32) verbunden ist.

8. Leuchtvorrichtung mit einem Anschlusssockel (30), der einen Kolben (26) trägt, in dem eine Licht emittierende Leuchtanordnung (24) angeordnet ist, **dadurch gekennzeichnet, dass** die Leuchtanordnung (24) nach einem der Ansprüche 5 bis 7 ausgebildet ist.
